# EUROPEAN PATENT APPLICATION

(11) **EP 2 088 673 A1**
(43) Date of publication of application: **12.08.2009**
(21) Application number: 09000768.3
(22) Date of filing: 20.01.2009
(51) Int. Cl.: H03J 1/00, H04B 15/06

(54) **Receiving apparatus**

(30) Priority: 06.02.2008 JP 2008026482
(71) Applicant: Alps Electric Co., Ltd., Tokyo 145-8501 (JP)
(72) Inventor: Tominaga, Atsushi, Ota-ku, Tokyo 145-8501 (JP)
(74) Representative: Klunker . Schmitt-Nilson . Hirsch

(57) **Abstract**

Provided is a receiving apparatus capable of preventing interference between tuners caused by oscillation frequencies while suppressing an increase in cost. In the receiving apparatus having an audio tuner (10) and a traffic information tuner (20) which are connected to an FM antenna (1) through a divider 2 for use in Japan, an oscillation frequency of the audio tuner 10 is set to (RF-IF)x3, an oscillation frequency of the traffic information tuner (20) is set to (RF-IF)x2, a dividing ratio of the audio tuner 10 is set to N=3, and a dividing ratio of the traffic information tuner 20 is set to N=2. For use in the other countries, the oscillation frequency and the dividing ratio of the audio tuner (10) are set to (RF+IF)x2 and N=2, respectively, and the oscillation frequency the dividing ratio of the traffic information tuner (20) are set to (RF+IF)x3 and N=3, respectively.

## Description

### Cross Reference to Related Applications

The present invention contains subject matter related to Japanese Patent Application No. 2008-026482 filed in the Japanese Patent Office on February 6, 2008, the entire contents of which being incorporated herein by reference.

### BACKGROUND

### 1. Technical Field

The present invention relates to a receiving apparatus having two tuners of which portions of reception frequency ranges overlap such as an audio receiving FM tuner and a traffic information receiving FM tuner.

### 2. Related Art

Currently, services for transmitting in real time road traffic information collected, processed, and edited by a road traffic information and communications system center and the like from an FM broadcasting station using a FM multiplex broadcasting technology have been provided. Particularly, for those services, a 2-tuner mode using an audio receiving FM tuner and a traffic information receiving FM tuner has been employed by a receiving apparatus.

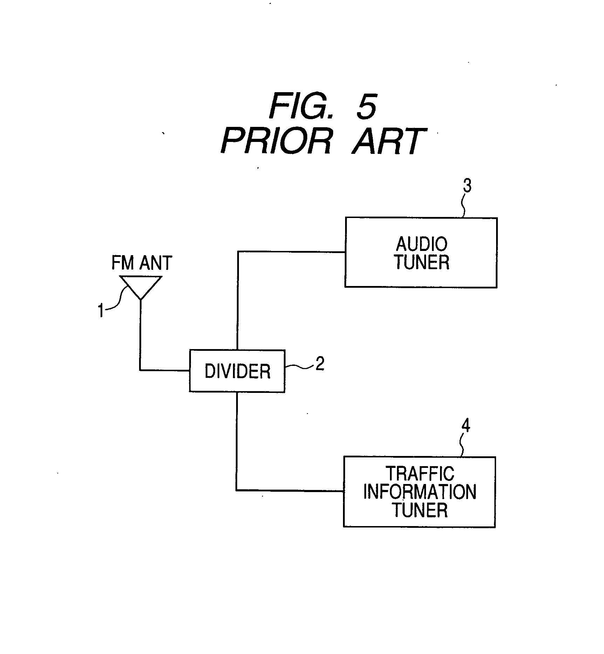

Fig. 5 is a schematic view illustrating a receiving apparatus employing the 2-tuner mode. A high frequency FM reception signal received by an FM antenna 1 is divided by a divider 2 to be transmitted to an audio receiving FM tuner (hereinafter, referred to as an audio tuner) 3 and a traffic information receiving FM tuner (hereinafter, referred to as a traffic information tuner) 4. The audio tuner 3 and the traffic information tuner 4 perform frequency conversion on the FM reception signal to be converted to an intermediate frequency signal by mixing the FM reception signal with a local oscillator signal at an oscillation frequency described later. In Japan, when a frequency of the FM receiving signal and a frequency of the intermediate frequency signal are denoted by RF and IF, respectively, an oscillator signal that oscillates at (RF-IF) x3 is divided into three signals for use as the local oscillator signal. In the other countries, an oscillator signal that oscillates at (RF+IF) x2 is divided into two signals to be used as the local oscillator signal. By mixing the FM reception signal with the local oscillator signal described above, the FM reception signal is converted into the intermediate frequency signal IF and output to a subsequent circuit.

However, there is a possibility that the oscillator signals used for the audio tuner 3 and the traffic information tuner 4 may leak through the divider 2. Therefore, when the oscillation frequencies of the two tuners 3 and 4 are equal, interference occurs. Accordingly, in the existing receiving apparatus, with respect to the intermediate frequency IF (for example, 10.7 MHz) of the audio tuner 3, the intermediate frequency IF of the traffic information tuner 4 is shifted to 15 MHz or 25 MHz, thereby providing different oscillation frequencies.

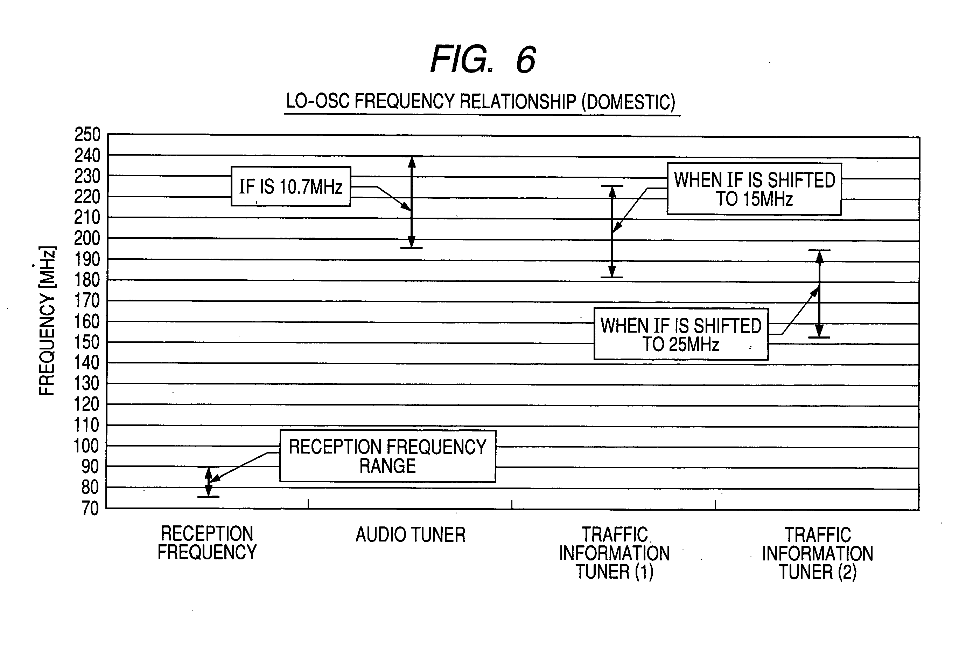

Fig. 6 is a view illustrating a relationship between the oscillation frequencies of the two tuners 3 and 4 when the intermediate frequency IF of the traffic information tuner 4 is shifted to 15 or 25 MHz for use in Japan. A reception frequency of the FM signal illustrated in Fig. 6 is in the range of 76 to 90 MHz. The audio tuner 3 extracts audio data from the FM signal in the reception frequency range. Accordingly, when IF=10.7 MHz, the oscillation frequency (RF-IF)x3 is in the range of 195.9 to 237.9 MHz. According to this, in the traffic information tuner 4, when IF=15 MHz, the oscillation frequency (RF-IF)x3 is in the range of 183. 0 to 225.0 MHz. When the IF of the traffic information tuner 4 is 25 MHz, the oscillation frequency (RF-IF)x3 is in the range of 153 to 195 MHz.

As illustrated in Fig. 6, by setting the traffic information tuner 4 to IF=15 MHz when the audio tuner 3 is set to IF=10.7 MHz, the oscillation frequency ranges of the two tuners 3 and 4 are relatively misaligned. In addition, when the IF of the traffic information tuner 4 is set to 25 MHz, the oscillation frequency ranges of the two tuners 3 and 4 hardly overlap with each other.

The shift of the IF to 15 MHz have been implemented by using a ceramic filter, and in order to solve a problem with the partly overlapping oscillation frequency ranges of the two tuners 3 and 4, isolation of the divider 2 is increased. In addition, when the IF of the traffic information tuner 4 is shifted to 25 MHz, in order to solve the aforementioned problem, a filter using a piezoelectric element is employed.

An example of the existing receiving apparatus is disclosed in JP-A-3-089720.

### SUMMARY

However, using the ceramic filter is related to an increase in cost. In addition, since there is a limitation to the isolation of the divider 2, there is a problem in that a higher isolation requires a greater circuit size. In addition, the filter having the piezoelectric element is more expensive than the ceramic filter and thus disadvantageous in terms of cost as compared with the ceramic filter.

It is desirable to provide a receiving apparatus capable of preventing interference between oscillator signals of two tuners while suppressing an increase in cost, thereby achieving an improvement in reception.

According to an aspect of the invention, the receiving apparatus includes a first tuner having a first local oscillator circuit and a second tuner having a second local oscillator circuit which are connected to an antenna through a divider so that at least portions of reception frequency ranges of the first and second tuners overlap with each other, wherein oscillation frequency ranges of the first and second local oscillator circuits are set so as not to overlap with each other.

With such a configuration, since the oscillation frequency ranges of the first and second local oscillator circuits are set so as not to overlap with each other, an intermediate frequency used for the second tuner does not need to be shifted with respect to an intermediate frequency used for the first tuner. In addition, even though one of the intermediate frequencies is not shifted by using a piezoelectric element filter, interference therebetween can be prevented.

In the receiving apparatus according to the aspect of the invention, the first and second tuners may perform frequency conversion by inputting high frequency reception signals divided by the divider to corresponding mixer circuits, dividing oscillator signals oscillated by the first and second local oscillator circuits by using corresponding divider circuits, and then inputting the divided oscillator signals to the corresponding mixer circuits, dividing ratios of the divider circuits included in the first and second tuners may be different.

With such a configuration, the oscillation frequency ranges of the first and second local oscillator circuits are different and correspondingly the dividing ratios of the first and second tuners are different. Therefore, for example, the first and second tuners can perform frequency conversion on the same intermediate frequency.

In the receiving apparatus according to the aspect of the invention, an oscillation frequency of the first local oscillator circuit may be set to a triple of a frequency (RF-IF) obtained by subtracting an intermediate frequency IF after the frequency conversion in the first tuner from a reception frequency RF of the high frequency reception signal, and an oscillation frequency of the second local oscillator circuit may be set to a double of a frequency (RF-IF) obtained by subtracting an intermediate frequency IF after the frequency conversion in the second tuner from the reception frequency RF of the high frequency reception signal.

With such a configuration, in the receiving apparatus for use in Japan, the oscillation frequency ranges of the first and second local oscillator circuits can be set so as not to overlap with each other.

In the receiving apparatus according to the aspect of the invention, an oscillation frequency of the first local oscillator circuit may be set to a double of a frequency (RF+IF) obtained by adding an intermediate frequency IF after the frequency conversion in the first tuner to the reception frequency RF of the high frequency reception signal, and an oscillation frequency of the second local oscillator circuit may be set to a triple of a frequency (RF+IF) obtained by adding an intermediate frequency IF after the frequency conversion in the second tuner to the reception frequency RF of the high frequency reception signal.

With such a configuration, in the receiving apparatus for use in the other countries, the oscillation frequency ranges of the first and second local oscillator circuits can be set so as not to overlap with each other.

In the receiving apparatus according to the aspect of the invention, the first tuner may be an audio receiving FM tuner, and the second tuner may be a traffic information receiving FM tuner.

According to the aspect of the invention, interference caused by the oscillator signals of the two tuners can be prevented while suppressing an increase in cost, thereby achieving an improvement in reception.

### BRIEF DESCRIPTION OF THE DRAWINGS

Fig. 1 is a schematic view mainly illustrating a tuner unit of a receiving apparatus according to an embodiment of the invention.
Fig. 2 is a view illustrating a relationship between an oscillation frequency of an audio tuner and an oscillation frequency of a traffic information tuner according to the embodiment.
Fig. 3 is a view illustrating oscillation frequency ranges of the audio tuner and the traffic information tuner for use in Japan.
Fig. 4 is a view illustrating oscillation frequency ranges of the audio tuner and the traffic information tuner for use in the other countries.
Fig. 5 is a schematic view illustrating an existing receiving apparatus employing a 2-tuner mode.
Fig. 6 is a view illustrating an oscillation frequency range in a case where an intermediate frequency IF of a traffic information tuner is shifted to 15 or 25 MHz.

### DESCRIPTION OF EXEMPLARY EMBODIMENTS

Hereinafter, exemplary embodiments of the invention will be described in detail with reference to the accompanying drawings.

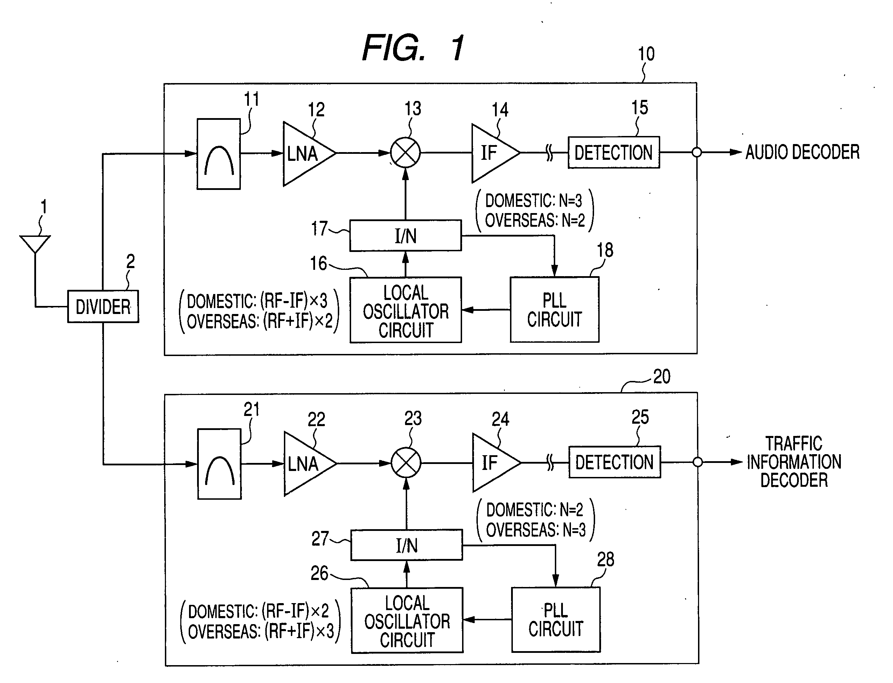

Fig. 1 is a schematic view mainly illustrating a tuner unit of a receiving apparatus according to an embodiment of the invention. The receiving apparatus according to the embodiment includes an audio tuner 10 for receiving an audio signal from an FM multiplex broadcasting signal as a first tuner and a traffic information tuner 20 for receiving a traffic information signal from the FM multiplex broadcasting signal as a second tuner. The audio tuner 10 and the traffic information tuner 20 are connected to an FM antenna 1 through a divider 2.

In the audio tuner 10, an FM reception signal divided by the divider 2 is input to a tunable filter 11 to extract an FM band, amplified by a low-noise amp 12, and input to a mixer circuit 13. The mixer circuit 13 performs frequency conversion on the FM reception signal to be converted into an intermediate frequency signal by adding a local oscillator signal described later. The intermediate frequency signal (IF) output from the mixer circuit 13 is amplified by an IF amp 14. The intermediate frequency signal amplified by the IF amp 14 is frequency-converted again by a mixer circuit not shown, an audio signal component is extracted by a band-pass filter therefrom and input to a detection circuit 15, and a detection signal detected by the detection circuit 15 is transmitted to a subsequent audio decoder. As the local oscillator signal input to the mixer circuit 13, an oscillator signal that oscillates at an oscillation frequency described later in a local oscillator circuit 16 as a first local oscillator circuit is divided by a divider 17, thereby obtaining the local oscillator signal. The oscillation frequency of the local oscillator circuit 16 is controlled by a PLL circuit 18.

The traffic information tuner 20 has the same basic circuit configuration as the audio tuner 10, except for an oscillation frequency in a local oscillator circuit and a dividing ratio in a divider. In the traffic information tuner 20, the FM reception signal divided by the divider 2 is input to a tunable filter 21 to extract an FM band, amplified by a low-noise amp 22, and input to a mixer circuit 23. The mixer circuit 23 performs frequency conversion on the FM reception signal to be converted into an intermediate frequency signal by adding a local oscillator signal. The intermediate frequency signal (IF) output from the mixer circuit 23 is amplified by an IF amp 24 and frequency-converted by a mixer circuit not shown, and a traffic information signal component is then extracted therefrom by a band-pass filter and input to a detection circuit 25. A detection signal detected by the detection circuit 25 is transmitted to a subsequent traffic information decoder. As the local oscillator signal input to the mixer circuit 23, an oscillator signal that oscillates at an oscillation frequency described later in a local oscillator circuit 26 as a second local oscillator circuit is divided by a divider 27, thereby obtaining the local oscillator signal. The oscillation frequency of the local oscillator circuit 26 is controlled by a PLL circuit 28.

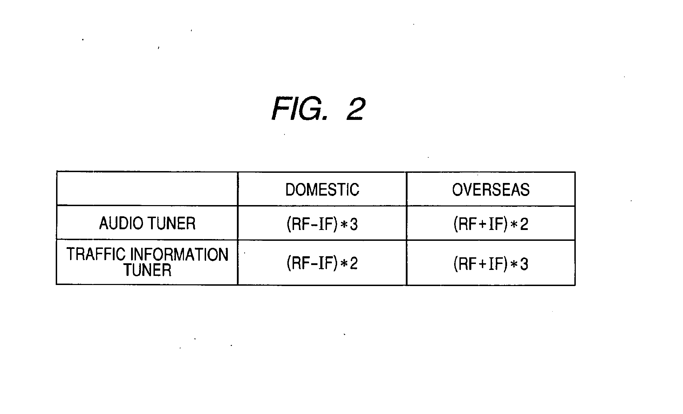

Fig. 2 illustrates a relationship between the oscillation frequency of the local oscillator circuit 16 in the audio tuner 10 and the oscillation frequency of the local oscillator circuit 26 of the traffic information tuner 20. In the receiving apparatus for use in Japan, the oscillation frequency of the audio tuner 10 is set to (RF-IF)x3, and the oscillation frequency of the traffic information tuner 20 is set to (RF-IF)x2. In addition, the dividing ratio of the divider 17 in the audio tuner 10 is set to N=3, so that the oscillation frequency (RF-IF)x3 divided into three frequencies is used as the local oscillator signal in the audio tuner 10. The dividing ratio of the divider 27 in the traffic information tuner 20 is set to N=2, so that the oscillation frequency (RF-IF)x2 divided into two frequencies is used as the local oscillator signal in the traffic information tuner 20.

Similarly, in the receiving apparatus for use in the other countries, the oscillation frequency of the audio tuner 10 is set to (RF+IF)x2, and the oscillation frequency of the traffic information tuner 20 is set to (RF+IF)x3. In addition, the dividing ratio of the divider 17 in the audio tuner 10 is set to N=2, so that the oscillation frequency (RF+IF) x2 divided into two frequencies is used as the local oscillator signal by the audio tuner 10. The dividing ratio of the divider 27 in the traffic information tuner 20 is set to N=3, so that the oscillation frequency (RF+IF) x3 divided into three frequencies is used as the local oscillator signal by the traffic information tuner 20.

Next, operations of the receiving apparatus having the aforementioned configuration according to the embodiment are described.

First, a case where the oscillation frequencies of the two tuners 10 and 20 are set for use in Japan is described. In the audio tuner 10, by using a desired wave frequency RF of the FM reception signal and the intermediate frequency IF after the frequency conversion in the mixer circuit 13, the oscillation frequency of the local oscillator circuit 16 is set to (RF-IF)x3, and the dividing ratio of the divider 17 is set to N=3. Accordingly, in the audio tuner 10, the oscillation frequency of the local oscillator circuit 16 is fixed to (RF-IF)x3 by the PLL circuit 18.

In the traffic information tuner 20, by using a desired wave frequency RF of the FM reception signal and the intermediate frequency IF after the frequency conversion in the mixer circuit 23, the oscillation frequency of the local oscillator circuit 26 is set to (RF-IF)x2, and the dividing ratio of the divider 27 is set to N=2. Accordingly, in the traffic information tuner 20, the oscillation frequency of the local oscillator circuit 26 is set to (RF-IF)x2 by the PLL circuit 28.

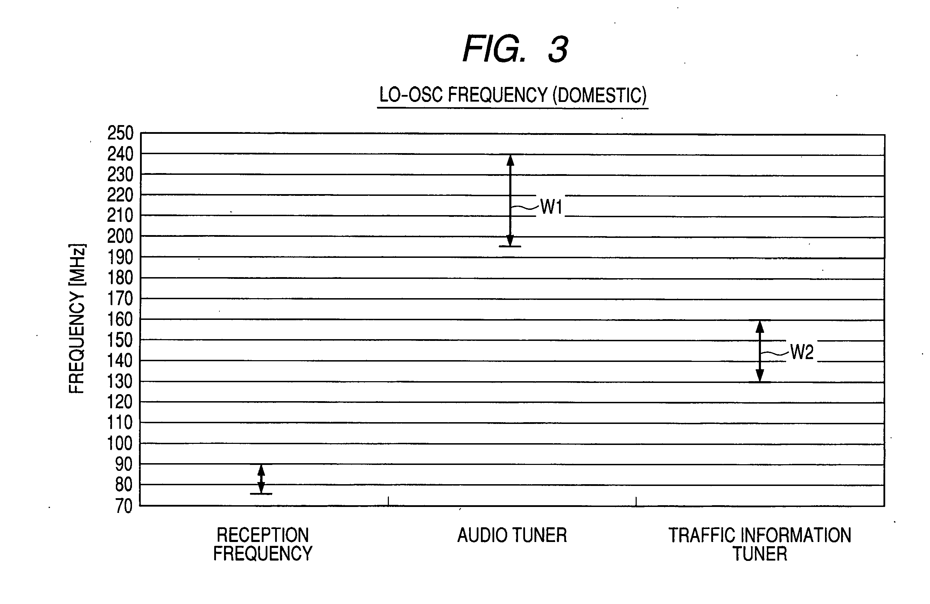

Fig. 3 illustrates a relationship between the oscillation frequency (RF-IF)x3 of the local oscillator circuit 16 in the audio tuner 10 and the oscillation frequency (RF-IF)x2 of the local oscillator circuit 26 in the traffic information tuner 20. As illustrated in Fig. 3, a frequency range W1 of the oscillation frequency (RF-IF)x3 of the audio tuner 10 and a frequency range W2 of the oscillation frequency (RF-IF)x2 of the traffic information tuner 20 do not overlap and are far enough from each other.

Next, a case where the oscillation frequencies of the two tuners 10 and 20 are set for use in the other countries is described. In the audio tuner 10, the oscillation frequency of the local oscillator circuit 16 is set to (RF+IF)x2, and the dividing ratio of the divider 17 is set to N=2. Accordingly, in the audio tuner 10, the oscillation frequency of the local oscillator circuit 16 is fixed to (RF+IF) x2 by the PLL circuit 18.

In the traffic information tuner 20, the oscillation frequency of the local oscillator circuit 26 is set to (RF+IF) x3, and the dividing ratio of the divider 27 is set to N=3. Accordingly, in the traffic information tuner 20, the oscillation frequency of the local oscillator circuit 26 is fixed to (RF+IF)x3 by the PLL circuit 28.

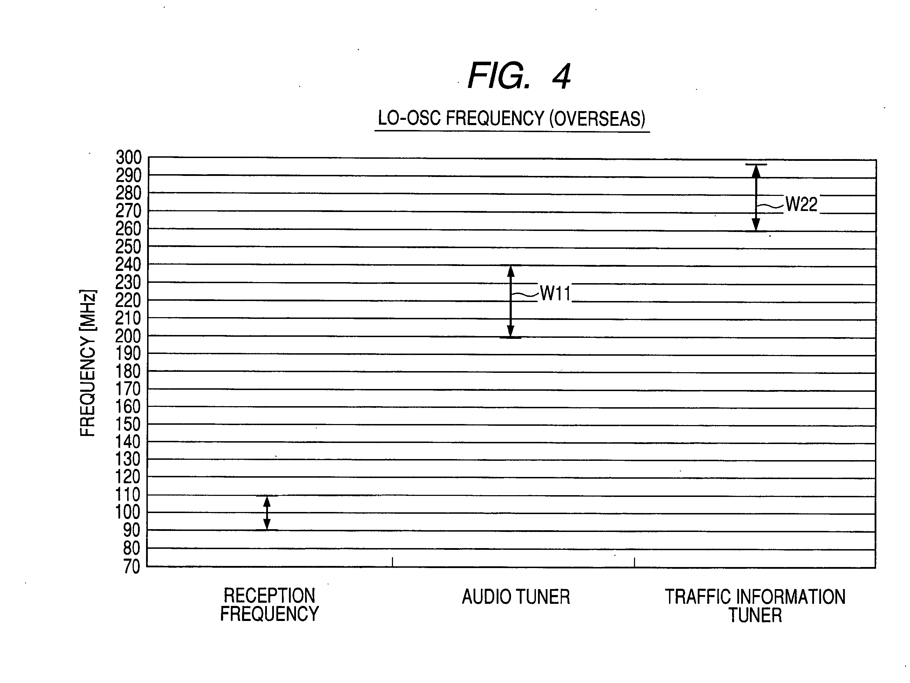

Fig. 4 illustrates a relationship between the oscillation frequency (RF+IF)x2 of the local oscillator circuit 16 in the audio tuner 10 and the oscillation frequency (RF+IF)x3 of the local oscillator circuit 26 in the traffic information tuner 20. As illustrated in Fig. 4, a frequency range W11 of the oscillation frequency (RF+IF)x2 of the audio tuner 10 and a frequency range W22 of the oscillation frequency (RF+IF)x3 of the traffic information tuner 20 do not overlap and are far enough from each other.

As described above, according to the embodiment, for both of the uses in Japan and the other countries, the audio tuner 10 and the traffic information tuner 20 generate the different oscillator signals in the different frequency ranges (W1 and W2, respectively, for use in Japan, and W11 and W22, respectively, for use in the other countries), so that interference cause by the overlapping oscillation frequencies of the two tuners 10 and 20 can be prevented. In addition, the intermediate frequency of the traffic information tuner 20 does not need to be shifted to another frequency (15 MHz or 25 MHz) with respect to the intermediate frequency (10.7 MHz) of the audio tuner 10, so that a ceramic filter or a filter using a piezoelectric element for shifting the frequency is not needed, and it is possible to reduce the number of components and costs.

In the above description, the receiving apparatus for receiving the FM multiplex transmission signal obtained by multiplexing the audio signal with the traffic information is described. However, any receiving apparatus including two tuners may be applied thereto.

The invention can be applied to a receiving apparatus which divides a reception signal input through an antenna by using a divider to be input to two tuners.

It should be understood by those skilled in the art that various modifications, combinations, sub-combinations and alterations may occur depending on design requirements and other factors insofar as they are within the scope of the appended claims of the equivalents thereof.

## Claims

1. A receiving apparatus comprising a first tuner having a first local oscillator circuit and a second tuner having a second local oscillator circuit which are connected to an antenna through a divider so that at least portions of reception frequency ranges of the first and second tuners overlap with each other, wherein oscillation frequency ranges of the first and second local oscillator circuits are set so as not to overlap with each other.

2. The receiving apparatus according to claim 1,
wherein the first and second tuners perform frequency conversion by inputting high frequency reception signals divided by the divider to corresponding mixer circuits, dividing oscillator signals oscillated by the first and second local oscillator circuits by using corresponding divider circuits, and then inputting the divided oscillator signals to the corresponding mixer circuits, and
wherein dividing ratios of the divider circuits included in the first and second tuners are different.

3. The receiving apparatus according to claim 1 or 2,
wherein an oscillation frequency of the first local oscillator circuit is set to a triple of a frequency (RF-IF) obtained by subtracting an intermediate frequency IF after the frequency conversion in the first tuner from a reception frequency RF of the high frequency reception signal, and
wherein an oscillation frequency of the second local oscillator circuit is set to a double of a frequency (RF-IF) obtained by subtracting an intermediate frequency IF after the frequency conversion in the second tuner from the reception frequency RF of the high frequency reception signal.

4. The receiving apparatus according to claim 1 or 2,
wherein an oscillation frequency of the first local oscillator circuit is set to a double of a frequency (RF+IF) obtained by adding an intermediate frequency IF after the frequency conversion in the first tuner to the reception frequency RF of the high frequency reception signal, and
wherein an oscillation frequency of the second local oscillator circuit is set to a triple of a frequency (RF+IF) obtained by adding an intermediate frequency IF after the frequency conversion in the second tuner to the reception frequency RF of the high frequency reception signal.

5. The receiving apparatus according to any one of claims 1 to 4, wherein the first tuner is an audio receiving FM tuner, and the second tuner is a traffic information receiving FM tuner.
